# EUROPEAN PATENT APPLICATION

(11) **EP 4 768 943 A1**
(43) Date of publication of application: **01.07.2026**
(21) Application number: 25758422.7
(22) Date of filing: 17.02.2025
(51) Int. Cl.: G01R 31/382, G01R 31/378, G01R 31/389, G01R 31/396, G01R 19/10, H01M 4/136, H01M 10/44, H01M 10/48

(54) **BATTERY DIAGNOSTIC APPARATUS AND METHOD THEREOF**

(30) Priority: 21.02.2024 KR 20240024920; 31.01.2025 KR 20250012386
(71) Applicant: LG Energy Solution, Ltd., Seoul 07335 (KR)
(72) Inventor: LI, Guang Ri, Daejeon 34122 (KR); KIM, Dong Myung, Daejeon 34122 (KR); LEE, Bom Jin, Daejeon 34122 (KR); LEE, Dal Hoon, Daejeon 34122 (KR); PARK, Sin Young, Daejeon 34122 (KR); PARK, Byung Chun, Daejeon 34122 (KR)
(74) Representative: Plasseraud IP
(86) International application number: PCT/KR2025/002304
(87) International publication number: WO 2025/178338

(57) **Abstract**

A battery diagnostic device may include a memory that stores at least one instruction and at least one processor that executes the at least one instruction, and the at least one processor may be configured to execute a charging process in which a charging section of a specific charge rate and a first rest section are alternately repeated for a battery cell or execute a discharging process in which a discharging section of a specific discharge rate and a second rest section are alternately repeated for the battery cell, acquire a resistance of the battery cell while executing the charging process or the discharging process, and diagnose a charge capacity of the battery cell based on the resistance of the battery cell.

## Description

### TECHNICAL FIELD

### Cross-reference to Related Applications

This application claims priority from Korean Patent Application Nos. 10-2024-0024920, filed on February 21, 2024, and 10-2025-0012386, filed on January 31, 2025, the disclosures of which are incorporated by reference herein.

### Technical Field

Embodiments disclosed herein relate to a battery diagnostic device and a method thereof.

### BACKGROUND ART

In recent years, research and development for secondary batteries have been actively conducted. Here, secondary batteries are batteries capable of being recharged and discharged, and may be interpreted to encompass both conventional Ni/Cd batteries, Ni/MH batteries, or the like, and recent lithium ion batteries. In recent years, the lithium ion batteries have expanded their range of use to power sources for electric vehicles, making the batteries attract attention as a next-generation energy storage medium.

As various electronic devices become widespread due to the Fourth Industrial Revolution, battery usage is rapidly increasing. Batteries are gaining attention as an essential energy source in various fields such as electric vehicles, portable electronic devices, and renewable energy storage systems, and accordingly, the importance of battery state diagnosis technology for improving battery performance and reliability is increasing.

In particular, with the increasing demand for cost-effective battery cells, cost-effective battery cell state diagnosis technologies are attracting attention. These technologies may have unique characteristics that differ from other battery cell state diagnosis technologies. The cost-effective battery cell diagnosis technologies are being developed, and charging is controlled depending on the state of the battery cells, so that battery reliability may be improved.

### DISCLOSURE OF THE INVENTION

### TECHNICAL PROBLEM

Embodiments disclosed herein are directed to providing a battery diagnostic device and a method thereof for identifying a charge capacity of a battery cell including lithium iron phosphate (LFP) as a positive electrode material.

Embodiments disclosed herein are directed to providing a battery diagnostic device and a method thereof for improving the accuracy of identifying a charge capacity of a battery cell including LFP as a positive electrode material.

Embodiments disclosed herein are directed to providing a battery diagnostic device and a method thereof for controlling a charge and discharge rate according to a charge capacity of a battery cell.

Embodiments disclosed herein are directed to providing a battery diagnostic device and a method thereof for improving the stability of a battery cell by controlling a charge and discharge rate according to a charge capacity of the battery cell.

The technical problems of the present disclosure are not limited to those mentioned above, and other objectives not mentioned will be clearly understood by those skilled in the art from the following descriptions.

### TECHNICAL SOLUTION

A battery diagnostic device according to an embodiment of the present disclosure may include a memory storing at least one instruction and at least one processor executing the at least one instruction.

According to an embodiment, the at least one processor may be configured to execute a charging process in which a charging section of a specific charge rate and a first rest section are alternately repeated for a battery cell or execute a discharging process in which a discharging section of a specific discharge rate and a second rest section are alternately repeated for the battery cell, acquire a resistance of the battery cell while executing the charging process or the discharging process, and diagnose a charge capacity of the battery cell based on the resistance of the battery cell.

According to an embodiment, the at least one processor may be configured to, when acquiring the resistance of the battery cell while executing the charging process, acquire the resistance of the battery cell based on a difference between a voltage of the battery cell in the charging section and a voltage of the battery cell in the first rest section and a current of the battery cell in the charging section.

According to an embodiment, the at least one processor may be configured to, when acquiring the resistance of the battery cell while executing the discharging process, acquire the resistance of the battery cell based on a difference between a voltage of the battery cell in the discharging section and a voltage of the battery cell in the second rest section and a current of the battery cell in the discharging section.

According to an embodiment, the at least one processor may be configured to diagnose the charge capacity of the battery cell based on a relationship between a resistance of a reference battery cell different from the battery cell and a charge capacity of the reference battery cell.

According to an embodiment, the at least one processor may be configured to diagnose the charge capacity of the battery cell based on the relationship corresponding to at least one of a temperature of the battery cell, the specific charge rate, the specific discharge rate, a state of life of the battery cell, or any combination thereof.

According to an embodiment, the at least one processor may be configured to, when the charge rate of the battery cell is containable in a specified charge rate range for a specified time or longer, acquire the resistance of the battery cell while executing the charging process.

According to an embodiment, the at least one processor may be configured to, when the discharge rate of the battery cell is containable in a specified discharge rate range for a predetermined time or longer, acquire the resistance of the battery cell while executing the discharging process.

According to an embodiment, the positive electrode of the battery cell may include lithium iron phosphate (LFP).

A battery diagnosis method according to an embodiment of the present disclosure may include executing a charging process in which a charging section of a specific charge rate and a first rest section are alternately repeated for a battery cell or execute a discharging process in which a discharging section of a specific discharge rate and a second rest section are alternately repeated for the battery cell, acquiring a resistance of the battery cell while executing the charging process or the discharging process, and diagnosing a charge capacity of the battery cell based on the resistance of the battery cell.

According to an embodiment, the acquiring of the resistance of the battery cell while executing the charging process or the discharging process may include acquiring, when acquiring the resistance of the battery cell while executing the charging process, the resistance of the battery cell based on a difference between a voltage of the battery cell in the charging section and a voltage of the battery cell in the first rest section and a current of the battery cell in the charging section.

According to an embodiment, the acquiring of the resistance of the battery cell while executing the charging process or the discharging process may include acquiring, when acquiring the resistance of the battery cell while executing the discharging process, the resistance of the battery cell based on a difference between a voltage of the battery cell in the discharging section and a voltage of the battery cell in the second rest section and a current of the battery cell in the discharging section.

According to an embodiment, the diagnosing of the charge capacity of the battery cell based on the resistance of the battery cell may include diagnosing the charge capacity of the battery cell based on a relationship between a resistance of a reference battery cell different from the battery cell and a charge capacity of the reference battery cell.

According to an embodiment, the diagnosing of the charge capacity of the battery cell based on the relationship between the resistance of the reference battery cell different from the battery cell and the charge capacity of the reference battery cell may include diagnosing the charge capacity of the battery cell based on the relationship corresponding to at least one of a temperature of the battery cell, the specific charge rate, the specific discharge rate, a state of life of the battery cell, or any combination thereof.

According to an embodiment, the acquiring of the resistance of the battery cell while executing the charging process or the discharging process may include acquiring, when the charge rate of the battery cell is containable in a specified charge rate range for a specified time or longer, the resistance of the battery cell while executing the charging process.

According to an embodiment, the acquiring of the resistance of the battery cell while executing the charging process or the discharging process may include acquiring, when the discharge rate of the battery cell is containable in a specified discharge rate range for a predetermined time or longer, the resistance of the battery cell while executing the discharging process.

According to an embodiment, the positive electrode of the battery cell may include lithium iron phosphate (LFP).

### ADVANTAGEOUS EFFECTS

The present technology can identify a charge capacity of a battery cell including lithium iron phosphate (LFP) as a positive electrode material.

In addition, the present technology can improve the accuracy of identifying a charge capacity of a battery cell including LFP as a positive electrode material.

In addition, the present technology can control a charge and discharge rate according to a charge capacity of a battery cell.

In addition, the present technology can improve the stability of a battery cell by controlling a charge and discharge rate according to a charge capacity of the battery cell.

Besides, various effects may be provided that are directly or indirectly identified through the present disclosure.

### BRIEF DESCRIPTION OF THE DRAWINGS

FIG. 1 is a block diagram showing a battery pack in a battery diagnostic device and a battery diagnosis method according to an embodiment of the present disclosure.
FIG. 2 is a block diagram showing the configuration of a battery diagnostic device, in the battery diagnostic device and a battery diagnosis method according to an embodiment of the present disclosure.
FIG. 3 illustrates an example of a graph showing a voltage of a battery cell according to a charge capacity of the battery cell using lithium iron phosphate (LFP) as a positive electrode material, in the battery diagnostic device and the battery diagnosis method according to an embodiment of the present disclosure.
FIG. 4 illustrates an example of a graph showing a current of the battery cell according to a charging process or a discharging process, in the battery diagnostic device and the battery diagnosis method according to an embodiment of the present disclosure.
FIG. 5 illustrates an example of a graph showing voltages of battery cells based on charge capacity of the battery cells identified for each of a plurality of charge rates, in the battery diagnostic device and the battery diagnosis method according to an embodiment of the present disclosure.
FIG. 6 illustrates an example of a flow of operations of the battery diagnostic device that diagnoses a charge capacity based on a process determined during the charging process or the discharging process, in the battery diagnostic device and the battery diagnosis method according to an embodiment of the present disclosure.
FIG. 7 illustrates an example of a flow of operations of the battery diagnostic device for diagnosing a charge capacity of a battery cell, in the battery diagnostic device and the battery diagnosis method according to an embodiment of the present disclosure.
FIG. 8 is a block diagram showing a hardware configuration of a computing system for performing a battery diagnosis method in a battery diagnostic device and the battery diagnosis method according to an embodiment of the present disclosure.

### MODE FOR CARRYING OUT THE INVENTION

Hereinafter, some embodiments disclosed herein are described with reference to the accompanying drawings of various embodiments of the present disclosure. However, this is not intended to limit the present technology to the specific embodiments, and it is to be construed to include various modifications, equivalents, and/or alternatives of embodiments of the present technology.

In adding reference numerals to the components of each drawing, it should be noted that the same components are given the same reference numerals as much as possible even though they are shown on different drawings. In addition, in describing various embodiments disclosed herein, when a detailed description of a related known configuration or function is determined to hinder understanding of the embodiments of the present invention, the detailed description thereof is omitted. It is to be understood that a singular form of a noun corresponding to an item may include one or more of the things, unless the relevant context clearly indicates otherwise.

In addition, in describing a component of the embodiments of the present disclosure, terms such as first, second, A, B, (a), (b), etc. may be used. These terms are only for distinguishing the component from other components, and the essence, sequence, or order of the component may not be limited by the terms. In addition, unless otherwise defined, all terms used herein, including technical or scientific terms, have the same meaning as commonly understood by those of ordinary skill in the art to which the embodiments disclosed herein belong. Terms, such as those defined in commonly used dictionaries, should be interpreted as having a meaning that is consistent with their meaning in the context of the related art and will not be interpreted in an idealized or overly formal sense unless expressly so defined herein.

In addition, in the present disclosure, in order to determine whether a specific condition is satisfied or fulfilled, expressions "more than" or "less than" may be used, but this is only a description for expressing an example and does not exclude descriptions of "equal to or more than" or "less than or equal to." A condition described as "equal to or more than" may be replaced with "more than," a condition described as "less than or equal to" may be replaced with "less than," and a condition described as "equal to or more than and less than" may be replaced with "more than and less than or equal to." In addition, hereinafter, "A to B" mean at least one of the elements from A (inclusive of A) to B (inclusive of B).

In the present disclosure, each of phrases such as "A or B," "at least one of A and B," "at least one of A or B," "A, B or C," "at least one of A, B and C," or "at least one of A, B, or C," may include any one of the items listed in the phrase, or all possible combinations of the phrases.

In the present specification, It is to be understood that if an element (e.g., a first element) is referred to, with or without the term "operatively" or "communicatively," as "connected to," "coupled to," or "in contact with" another element (e.g., a second element), it means that the element may be connected to the other element directly (e.g., by wire or wirelessly) or via a third element.

According to an embodiment, a method according to various embodiments disclosed herein may be included and provided in a computer program product. The computer program product may be traded as a product between a seller and a buyer. The computer program product may be distributed in the form of a machine-readable storage medium (e.g., a compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the described components may include a single entity or multiple entities, and some of the plurality of entities may be disposed separately from other components. According to various embodiments, at least one of the above-described components may be omitted, or at least one of other components may be added. Alternatively or additionally, a plurality of components (e.g., modules or programs) may be integrated into a single component. In such a case, the integrated component may still perform at least one function of each of the plurality of components in the same or similar manner as those performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or at least one of other operations may be added.

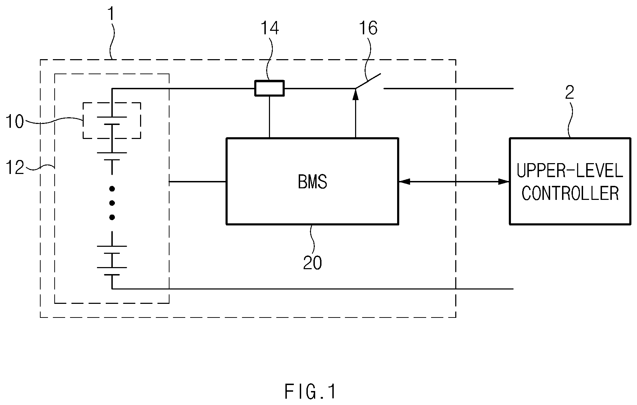

Hereinafter, embodiments of the present disclosure will be described in detail with reference to FIGS. 1 to 8.

FIG. 1 is a block diagram showing a battery pack in a battery diagnostic device and a battery diagnosis method according to an embodiment of the present disclosure.

Referring to FIG. 1, a battery pack 1 may include a battery unit 12, a sensor unit 14, a switching unit 16, and a battery management system (BMS) 20. In this case, the battery pack 1 may be equipped with a plurality of battery units 12, sensor units 14, switching units 16, and battery management systems 20.

According to an embodiment, the battery unit 12 may supply power to a target device (not shown). For this purpose, the battery unit 12 may be electrically connected to the target device. Here, the target device may include an electrical, electronic, or mechanical device that operates by receiving power from the battery pack 1. For example, the target device may be an electric vehicle (EV) or an energy storage system (ESS), but is not limited thereto.

According to an embodiment, the battery unit 12 may include at least one battery cell 10 that is rechargeable and dischargeable. Here, the battery cell 10 may be a basic unit of a battery cell that may be used by being charged and discharged with electric energy. For example, the battery cell 10 may be a lithium ion (Li-ion) battery, a lithium ion (Li-ion) polymer battery, a nickel cadmium (Ni-Cd) battery, a nickel hydrogen (Ni-MH) battery, or the like, and may not be limited thereto.

According to an embodiment, a plurality of battery units 12 may be connected in series or in parallel. For example, the battery unit 12 may be a battery module, a battery bank, or a collection of battery cells (cell-to-pack structure).

According to an embodiment, the sensor unit 14 may acquire information related to the battery unit 12. According to an embodiment, the sensor unit 14 may acquire values (or information) related to the state of each of the battery units 12 or battery cells 10. In an embodiment, the state-related values may include at least one value for voltage, current, resistance, state of charge (SOC), state of health (SOH), or temperature of the battery cell, or a combination thereof.

According to an embodiment, the sensor unit 14 may provide information on each of the plurality of battery units 12 to the battery management system 20.

According to an embodiment, the switching unit 16 may include a device for controlling the current flow for charging or discharging the battery unit 12. For example, the switching unit 16 may include at least one relay and/or magnetic contactor, depending on the specifications of the battery pack 1.

According to an embodiment, the battery management system (BMS) 20 may control or manage the battery pack 1 to prevent overcharge and over-discharge by monitoring the voltage, current, temperature, and the like of the battery pack 1. For example, the battery management system 20 may be an interface for receiving values obtained by measuring the above-mentioned various parameters, and may include a plurality of terminals, a circuit connected to the terminals to process input values, or the like. In addition, the battery management system 20 may control the sensor unit 14 and/or the switching unit 16. For example, the battery management system 20 may be connected to a plurality of battery units 12 to monitor the state of each of the plurality of battery units 12 and control ON/OFF of the relay, the contactor, or the like.

According to an embodiment, the operation of the battery management system 20 may be performed by the BMS (battery management system) in a vehicle, as well as by various devices such as a server, a cloud, a charger, a discharger, or the like.

An upper-level controller 2 may transmit a control signal for the plurality of battery units 12 to the battery management system 20. Accordingly, the operation of the battery management system 20 may be controlled based on the signal received from the upper controller 2.

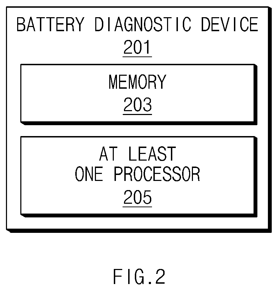

According to an embodiment, the battery management system 20 may include a battery diagnostic device 201 in FIG. 2. In another embodiment, the battery management system 20 may be a system different than the battery diagnostic device 201 in FIG. 2. That is, the battery diagnostic device 201 in FIG. 2 may be included in the battery pack 1 or may be configured as another device external to the battery pack 1. For convenience of explanation, the following description assumes that the battery diagnostic device 201 is constructed as another device external to the battery pack 1. In addition, the operation of the battery diagnostic device 201 below may be performed by a battery management system (BMS) in the vehicle, as well as by various devices such as a server, a cloud, a charger, a discharger, or the like.

FIG. 2 is a block diagram showing the configuration of a battery diagnostic device, in the battery diagnostic device and a battery diagnosis method according to an embodiment of the present disclosure.

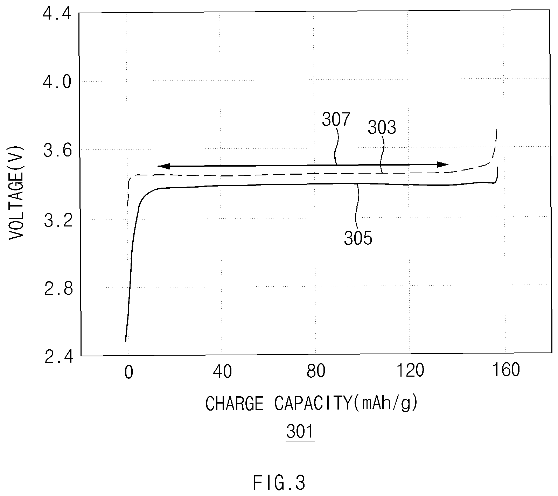

FIG. 3 illustrates an example of a graph showing a voltage of a battery cell according to a charge capacity of the battery cell using lithium iron phosphate (LFP) as a positive electrode material, in the battery diagnostic device and the battery diagnosis method according to an embodiment of the present disclosure.

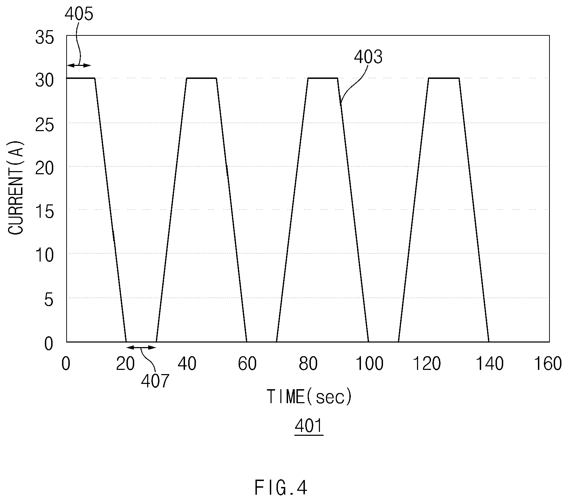

FIG. 4 illustrates an example of a graph showing a current of the battery cell according to a charging process or a discharging process, in the battery diagnostic device and the battery diagnosis method according to an embodiment of the present disclosure.

Referring to FIGS. 2, 3, and 4, a battery diagnostic device 201 may include a memory 203 and at least one processor 205. The memory 203 may store at least one instruction. The at least one processor 205 may execute the at least one instruction.

A first graph 301 may represent the voltage of the battery cell according to the charge capacity of the battery cell using LFP as a positive electrode material. A first line 303 may represent a voltage according to the charge capacity of the battery cell measured when the battery cell is charged. A second line 305 may represent a voltage according to the charge capacity of the battery cell measured when the battery cell is discharged. A first section 307 may represent a section in which a voltage change of the battery cell is less than a specified voltage change amount even when the charge capacity of the battery cell changes.

A second graph 401 may represent the current of the battery cell over time while executing the charging process or the discharging process. A third line 403 may represent the current of the battery cell over time.

In the present disclosure, the charge capacity of the battery cell may be expressed as a state of charge (SOC), which is the charged capacity of the battery cell. The charge capacity of the battery cell represents a ratio of the remaining capacity to the full charge capacity of the battery cell, and may be expressed as a value between 0 and 1, or between 0% and 100%. For determining the charge capacity, methods such as ampere counting, an open circuit voltage (OCV)-SOC curve, Kalman filter, or the like may be utilized, but the embodiment of the present disclosure may not be limited thereto.

When a measurement accuracy of the charge capacity of the battery cell is lower than a specified accuracy, the battery cell may be overcharged or over-discharged, which may cause damage, and the life of the battery cell may be shortened due to the damage to the battery cell.

In addition, when the measurement accuracy of the charge capacity of the battery cells is lower than the specified accuracy, some battery cells may continue to operate under load, an imbalance may occur between some battery cells, or the electrolyte within some battery cells may decompose.

In addition, when the measurement accuracy of the charge capacity of the battery cell is lower than the specified accuracy, the thermal management system may not properly operate depending on the charge capacity of the battery cell, resulting in deterioration in the reliability of the battery cell.

Therefore, maintaining the measurement accuracy of the charge capacity of the battery cell higher than the specified accuracy may be necessary in terms of the stability and reliability of the battery cell.

At least one processor 205 of the battery diagnostic device 201 may diagnose the charge capacity of the battery cell, generally based on the voltage of the battery cell. However, for the battery cell including LFP as the positive electrode material, it may be difficult to diagnose the charge capacity according to a change in voltage, as in the first graph 301. This is because even when the charge capacity of the battery cell changes in a specific section, the voltage change of the battery cell may be less than the specified voltage change amount.

In other words, in the first section 307 of the first line 303 indicating the voltage according to the charge capacity of the battery cell measured when the battery cell is charged, and the second line 305 indicating the voltage according to the charge capacity of the battery cell measured when the battery cell is discharged, even when the charge capacity of the battery cell changes, the voltage change of the battery cell may be less than the specified voltage change amount.

According to an embodiment, at least one processor 205 of the battery diagnostic device 201 may identify a charge capacity of a battery cell based on the resistance of the battery cell including LFP as the positive electrode material.

According to an embodiment, at least one processor 205 of the battery diagnostic device 201 may acquire a resistance of a battery cell while performing the charging process or the discharging process.

According to an embodiment, the charging process may include a process in which a charging section of a specific charge rate and a first rest section are alternately repeated for the battery cell as in the second graph 401. For the charging process, the third line 403 may represent the charging current of the battery cell over time, a second section 405 may represent the charging section, and a third section 407 may represent the first rest section.

According to an embodiment, when acquiring the resistance of the battery cell while executing the charging process, at least one processor 205 of the battery diagnostic device 201 may acquire the resistance of the battery cell based on a difference between the voltage of the battery cell in the charging section (e.g., the second section 405) and the voltage of the battery cell in the first rest section (e.g., the third section 407) and the current of the battery cell in the charging section.

According to an embodiment, the discharging process may include a process in which a discharging section of a specific discharge rate and a second rest section are alternately repeated for the battery cell as in the second graph 401. For the discharging process, the third line 403 may represent the discharging current of the battery cell over time, the second section 405 may represent the discharging section, and the third section 407 may represent the second rest section.

According to an embodiment, when acquiring the resistance of the battery cell while executing the discharging process, at least one processor 205 of the battery diagnostic device 201 may acquire the resistance of the battery cell based on a difference between the voltage of the battery cell in the discharging section (e.g., the second section 405) and the voltage of the battery cell in the second rest section (e.g., the third section 407) and the current of the battery cell in the discharging section.

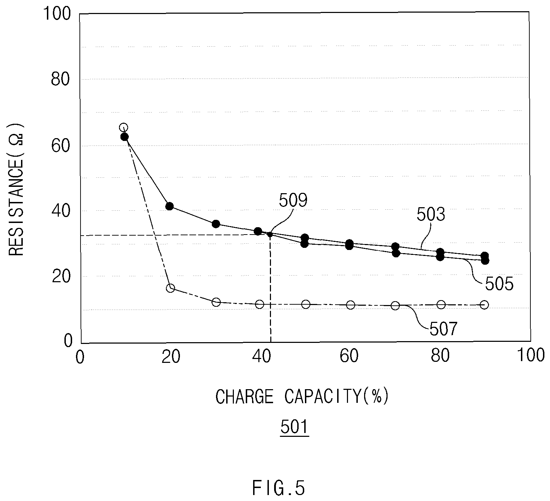

FIG. 5 illustrates an example of a graph showing voltages of battery cells based on charge capacity of the battery cells identified for each of a plurality of charge rates, in the battery diagnostic device and the battery diagnosis method according to an embodiment of the present disclosure.

Referring to FIG. 5, a graph 501 may represent a resistance according to the charge capacity of the battery cell. A first line 503 may represent a resistance of a first reference battery cell using LFP as a positive electrode material according to the charge capacity of the first reference battery cell. A second line 505 may represent a resistance of a second reference battery cell using LFP as a positive electrode material according to the charge capacity of the second reference battery cell. The third line 507 may represent a resistance of a comparative battery cell using lithium, nickel, cobalt, and manganese as a positive electrode material according to the charge capacity of the comparative battery cell. A point 509 may represent a measured resistance of the battery cell and the charge capacity of the battery cell according to the resistance.

According to an embodiment, at least one processor 205 of the battery diagnostic device 201 may diagnose the charge capacity of the battery cell based on a relationship between the resistance of the reference battery cell and the charge capacity of the reference battery cell.

According to an embodiment, the first reference battery cell and the second reference battery cell may be different from the battery cell. The resistance of the reference battery cell may be identified based on the resistance of each of a plurality of reference battery cells. For example, the resistance of the reference battery cell may include an average of the resistance of the first reference battery cell and the resistance of the second reference battery cell. For example, the resistance of the reference battery cell may include the resistance of the first reference battery cell, or the resistance of the second reference battery cell. However, the embodiment of the present disclosure may not be limited thereto.

According to an embodiment, at least one processor 205 of the battery diagnostic device 201 may diagnose the charge capacity of a battery cell by substituting the resistance of the battery cell into the relationship between the resistance of the reference battery cell and the charge capacity of the reference battery cell, as in the graph 501.

According to an embodiment, when the resistance value of the battery cell, as at the point 509, is measured to be about 30 Ω, at least one processor 205 of the battery diagnostic device 201 may diagnose the charge capacity of the battery cell as about 41% based on the relationship between the resistance of the reference battery cell and the charge capacity of the reference battery cell.

Referring to the third line 507, in the case of the comparative battery cell, it may be difficult to diagnose the charge capacity of the comparative battery cell based on the resistance of the comparative battery cell. This is because even when the resistance of the comparative battery cell changes in a specific section, the change in the charge capacity of the comparative battery cell is less than a specified capacity change amount.

According to an embodiment, at least one processor 205 of the battery diagnostic device 201 may diagnose the charge capacity of the battery cell based on the relationship between the resistance of the reference battery cell and the charge capacity of the reference battery cell corresponding to at least one of the temperature of the battery cell, a specific charge rate, a specific discharge rate, the state of life of the battery cell, or any combination thereof.

For example, when acquiring the resistance of the battery cell while executing the charging process, at least one processor 205 of the battery diagnostic device 201 may diagnose the charge capacity of the battery cell based on the relationship between the resistance of the reference battery cell and the charge capacity of the reference battery cell corresponding to at least one of the temperature of the battery cell, the charge rate of the battery cell in the charging section, the state of the life of the battery cell, or any combination thereof.

For example, when acquiring the resistance of the battery cell while executing the discharging process, at least one processor 205 of the battery diagnostic device 201 may diagnose the charge capacity of the battery cell based on the relationship between the resistance of the reference battery cell and the charge capacity of the reference battery cell corresponding to at least one of the temperature of the battery cell, the discharge rate of the battery cell in the discharging section, the state of the life of the battery cell, or any combination thereof.

According to an embodiment, at least one processor 205 of the battery diagnostic device 201 may acquire the resistance of the battery cell while executing the charging process when the charge rate of the battery cell is containable in a specified charge rate range for a specified time or longer, and diagnose the charge capacity of the battery cell based on the resistance of the battery cell. However, the embodiment of the present disclosure may not be limited thereto.

According to an embodiment, at least one processor 205 of the battery diagnostic device 201 may acquire the resistance of the battery cell while executing the discharging process when the discharge rate of the battery cell is containable in a specified discharge rate range for a predetermined time or longer, and diagnose the charge capacity of the battery cell based on the resistance of the battery cell. However, the embodiment of the present disclosure may not be limited thereto.

For example, since the charge rate of the battery cell included in the vehicle is containable in the specified charge rate range for the specified time or longer, but the discharge rate of the battery cell included in the vehicle is not containable in the specified discharge rate range for the predetermined time or longer, at least one processor 205 of the battery diagnostic device 201 may acquire the resistance of the battery cell while executing the charging process. However, the embodiment of the present disclosure may not be limited thereto.

For example, since the charge rate of the battery cell included in the energy storage system (ESS) is not containable in the specified charge rate range for the specified time or longer, but the discharge rate of the battery cell included in the ESS is containable for the predetermined time or longer, at least one processor 205 of the battery diagnostic device 201 may acquire the resistance of the battery cell while executing the discharging process. However, the embodiment of the present disclosure may not be limited thereto.

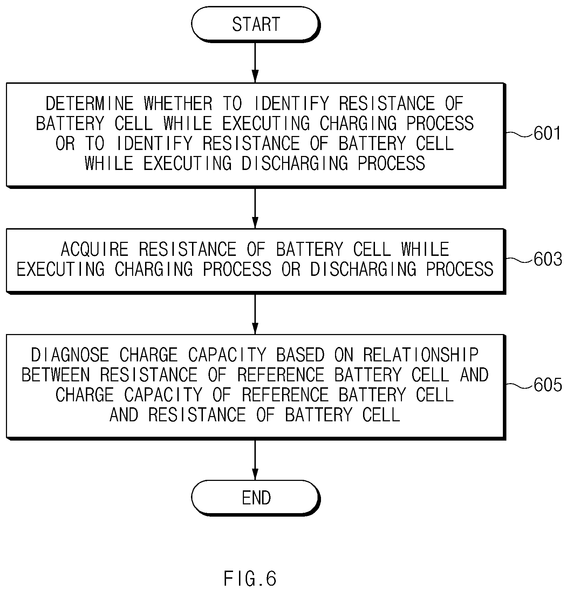

FIG. 6 illustrates an example of a flow of operations of the battery diagnostic device that diagnoses a charge capacity based on a process determined during the charging process or the discharging process, in the battery diagnostic device and the battery diagnosis method according to an embodiment of the present disclosure.

Hereinafter, it is assumed that at least one processor 205 included in the battery diagnostic device 201 in FIG. 2 performs the process of FIG. 6. In addition, in the description of FIG. 6, it may be understood that the operations described as being performed by the battery diagnostic device 201 are controlled by at least one processor 205 included in the battery diagnostic device 201.

Referring to FIG. 6, in first operation 601, at least one processor 205 of the battery diagnostic device 201 may determine whether to identify the resistance of the battery cell during while executing a charging process or to identify the resistance of the battery cell while executing the discharging process.

In second operation 603, at least one processor 205 of the battery diagnostic device 201 may identify the resistance of the battery cell while executing the charging process or the discharging process.

In third operation 605, at least one processor 205 of the battery diagnostic device 201 may diagnose the charge capacity based on the relationship between the resistance of the reference battery cell and the charge capacity of the reference battery cell, and the resistance of the battery cell.

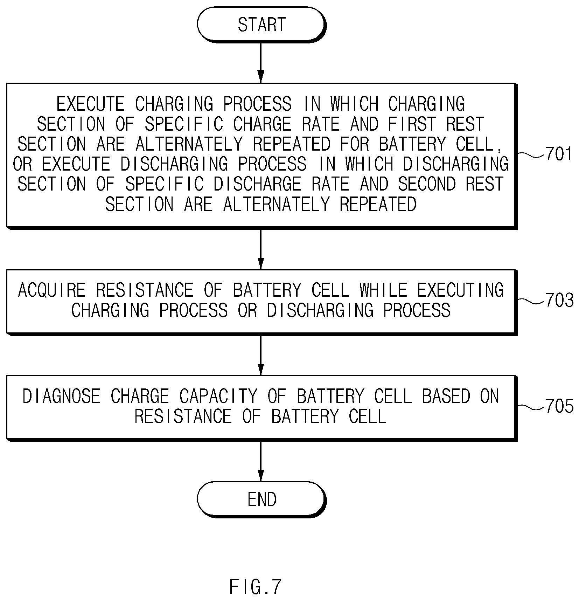

FIG. 7 illustrates an example of a flow of operations of the battery diagnostic device for diagnosing a charge capacity of a battery cell, in the battery diagnostic device and the battery diagnosis method according to an embodiment of the present disclosure.

Hereinafter, it is assumed that at least one processor 205 included in the battery diagnostic device 201 in FIG. 2 performs the process of FIG. 7. In addition, in the description of FIG. 7, it may be understood that the operations described as being performed by the battery diagnostic device 201 are controlled by at least one processor 205 included in the battery diagnostic device 201.

In first operation 701, at least one processor 205 of the battery diagnostic device 201 may execute a charging process in which a charging section of a specific charge rate and a first rest section are alternately repeated for the battery cell, or may execute a discharging process in which a discharging section of a specific discharge rate and a second rest section are alternately repeated.

In second operation 703, at least one processor 205 of the battery diagnostic device 201 may acquire the resistance of the battery cell while executing the charging process or the discharging process.

In third operation 705, at least one processor 205 of the battery diagnostic device 201 may diagnose the charge capacity of the battery cell based on the resistance of the battery cell.

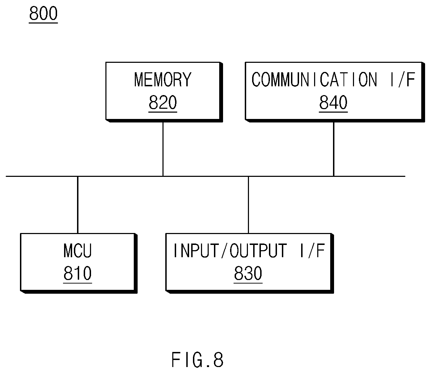

FIG. 8 is a block diagram showing a hardware configuration of a computing system for performing a battery diagnosis method in a battery diagnostic device and the battery diagnosis method according to an embodiment of the present disclosure.

Referring to FIG. 8, a computing system 800 according to an embodiment disclosed herein may include a microcontroller unit (MCU) 810, a memory 820, an input/output interface (I/F) 830, and a communication I/F 840.

The MCU 810 may be one or more processors that execute various programs (e.g., a battery cell data collection program, a graph generation program, a data analysis program, a data decomposition algorithm, a normalization program, a battery cell diagnosis program, and the like) stored in the memory 820, process various pieces of information including battery cell characteristic data, latent variables, and the like through the programs, and perform functions of the battery diagnostic device 201 shown in the above-described FIGS. 2 to 7.

The memory 820 may store various programs such as the battery cell data collection program, the graph generation program, the data analysis program, the data decomposition algorithm, the normalization program, the battery cell diagnosis program, and the like.

A plurality of memories 820 may be provided as needed. The memory 820 may be a volatile memory or non-volatile memory. As the volatile memory, the memory 820 may be a random access memory (RAM), dynamic RAM (DRAM), static RAM (SRAM), or the like. As the nonvolatile memory, for the memory 820, a read-only memory (ROM), a programmable ROM (PROM), an electrically alterable ROM (EAROM), an erasable programmable ROM (EPROM), an electrically erasable programmable ROM (EEPROM), a flash memory, or the like. The examples of memories 820 listed above are only exemplary and are not limited to the examples.

The input/output I/F 830 may provide an interface that enables data to be transmitted and received by connecting an input device (not illustrated) such as a keyboard, mouse, or touch panel, and an output device (not illustrated) such as a display and the MCU 810.

The communication I/F 840 is a component capable of transmitting and receiving various data with a server, and may be any device capable of supporting wired or wireless communication. For example, the battery diagnostic device 201 may transmit and receive various types of information, including a shape model of a battery cell or the like, to and from a separately provided external server through the communication I/F 840.

By being recorded in the memory 820 and processed by the MCU 810 in this way, a computer program according to an embodiment disclosed herein may be implemented, for example, as a module that performs each of the functions shown in FIG. 2.

Although all the components constituting the embodiments disclosed herein have been described as being combined or operating in combination as one, the embodiments disclosed herein are not necessarily limited to these embodiments. That is, within the scope of the purpose of the embodiments disclosed herein, all of the components may be selectively combined and operated one or more times.

Terms such as "include," "comprise," or "have" described above mean that the corresponding component can be present unless otherwise stated, and thus it should be construed that other components may be further included rather than excluding other components. All terms including technical or scientific terms have the same meaning as commonly understood by those of ordinary skill in the art to which embodiments disclosed herein belong, unless otherwise defined. Terms commonly used such as those defined in dictionaries should be interpreted as having a meaning that is consistent with their meaning in the context of the related art and will not be interpreted in an idealized or overly formal sense unless expressly so defined herein.

The foregoing disclosure outlines features of several embodiments so that those skilled in the art may better understand the aspects of the present disclosure. Those skilled in the art will appreciate that the present disclosure may readily serve as a basis for designing or modifying other structures for carrying out the same purposes or achieving the same advantages of the embodiments introduced herein. Furthermore, those skilled in the art will recognize that such equivalent configurations do not depart from the scope of the present disclosure, and that various changes, substitutions, and modifications may be made herein without departing from the scope of the present disclosure.

## Claims

1. A battery diagnostic device comprising:
a memory that stores at least one instruction; and
at least one processor that executes the at least one instruction,
wherein the at least one processor is configured to:
execute a charging process in which a charging section of a specific charge rate and a first rest section are alternately repeated for a battery cell or execute a discharging process in which a discharging section of a specific discharge rate and a second rest section are alternately repeated for the battery cell;
acquire a resistance of the battery cell while executing the charging process or the discharging process; and
diagnose a charge capacity of the battery cell based on the resistance of the battery cell.

2. The battery diagnostic device of claim 1, wherein the at least one processor is configured to, when acquiring the resistance of the battery cell while executing the charging process, acquire the resistance of the battery cell based on a difference between a voltage of the battery cell in the charging section and a voltage of the battery cell in the first rest section and a current of the battery cell in the charging section.

3. The battery diagnostic device of claim 1, wherein the at least one processor is configured to, when acquiring the resistance of the battery cell while executing the discharging process, acquire the resistance of the battery cell based on a current of the battery cell in the discharging section and a difference between a voltage of the battery cell in the discharging section and a voltage of the battery cell in the second rest section.

4. The battery diagnostic device of claim 1, wherein the at least one processor is configured to diagnose the charge capacity of the battery cell based on a relationship between a resistance of a reference battery cell different from the battery cell and a charge capacity of the reference battery cell.

5. The battery diagnostic device of claim 4, wherein the at least one processor is configured to diagnose the charge capacity of the battery cell based on the relationship corresponding to at least one of a temperature of the battery cell, the specific charge rate, the specific discharge rate, a state of life of the battery cell, or any combination thereof.

6. The battery diagnostic device of claim 1, wherein the at least one processor is configured to, when the charge rate of the battery cell is containable in a specified charge rate range for a specified time or longer, acquire the resistance of the battery cell while executing the charging process.

7. The battery diagnostic device of claim 1, wherein the at least one processor is configured to, when the discharge rate of the battery cell is containable in a specified discharge rate range for a predetermined time or longer, acquire the resistance of the battery cell while executing the discharging process.

8. The battery diagnostic device of claim 1, wherein a positive electrode of the battery cell includes lithium iron phosphate (LFP).

9. A battery diagnosis method comprising:
executing a charging process in which a charging section of a specific charge rate and a first rest section are alternately repeated for a battery cell or execute a discharging process in which a discharging section of a specific discharge rate and a second rest section are alternately repeated for the battery cell;
acquiring a resistance of the battery cell while executing the charging process or the discharging process; and
diagnosing a charge capacity of the battery cell based on the resistance of the battery cell.

10. The battery diagnosis method of claim 9, wherein the acquiring of the resistance of the battery cell while executing the charging process or the discharging process includes acquiring, when acquiring the resistance of the battery cell while executing the charging process, the resistance of the battery cell based on a difference between a voltage of the battery cell in the charging section and a voltage of the battery cell in the first rest section and a current of the battery cell in the charging section.

11. The battery diagnosis method of claim 9, wherein the acquiring of the resistance of the battery cell while executing the charging process or the discharging process includes acquiring, when acquiring the resistance of the battery cell while executing the discharging process, the resistance of the battery cell based on a current of the battery cell in the discharging section and a difference between a voltage of the battery cell in the discharging section and a voltage of the battery cell in the second rest section.

12. The battery diagnosis method of claim 9, wherein the diagnosing of the charge capacity of the battery cell based on the resistance of the battery cell includes diagnosing the charge capacity of the battery cell based on a relationship between a resistance of a reference battery cell different from the battery cell and a charge capacity of the reference battery cell.

13. The battery diagnosis method of claim 12, wherein the diagnosing of the charge capacity of the battery cell based on the relationship between the resistance of the reference battery cell different from the battery cell and the charge capacity of the reference battery cell includes diagnosing the charge capacity of the battery cell based on the relationship corresponding to at least one of a temperature of the battery cell, the specific charge rate, the specific discharge rate, a state of life of the battery cell, or any combination thereof.

14. The battery diagnosis method of claim 9, wherein the acquiring of the resistance of the battery cell while executing the charging process or the discharging process includes acquiring, when the charge rate of the battery cell is containable in a specified charge rate range for a specified time or longer, the resistance of the battery cell while executing the charging process.

15. The battery diagnosis method of claim 9, wherein the acquiring of the resistance of the battery cell while executing the charging process or the discharging process includes acquiring, when the discharge rate of the battery cell is containable in a specified discharge rate range for a predetermined time or longer, the resistance of the battery cell while executing the discharging process.

16. The battery diagnosis method of claim 9, wherein a positive electrode of the battery cell includes lithium iron phosphate (LFP).
